# EUROPÄISCHE PATENTANMELDUNG

(11) **EP 2 037 286 A1**
(43) Veröffentlichungstag der Anmeldung: **18.03.2009**
(21) Anmeldenummer: 07017942.9
(22) Anmeldetag: 13.09.2007
(51) Int. Cl.: G01R 15/14, G01R 33/02, G01R 33/04, G01R 33/06

(54) **Messvorrichtung zur Messung eines magnetischen Felds**

(71) Anmelder: Micronas GmbH, 79108 Freiburg i. Br. (DE)
(72) Erfinder: Janke, Ralf, Dr., 79211 Denzlingen (DE)
(74) Vertreter: Huwer, Andreas

(57) **Zusammenfassung**

Eine Messvorrichtung (1) zur Messung eines magnetischen Felds (B) hat mindestens eine Messspule (3) und wenigstens einen Sensor zur Messung niederfrequenter Magnetfelder, weiche Messspule (3) und welcher Sensor mit ihrer Erstreckungsebene jeweils quer zur Flussrichtung des magnetischen Felds (B) in diesem positioniert oder positionierbar sind. Die Messspule (3) und der Sensor sind mit einer Signalverarbeitungseinrichtung (9) verbunden, mit der in Abhängigkeit von einem von der Messspule (3) bereitgestellten ersten Messsignal und einem vom Sensor bereitgestellten zweiten Messsignal ein dem magnetischen Feld (B) im Wesentlichen entsprechendes Ausgangssignal generierbar ist. Die Messspule (3), der Sensor und die Signalverarbeitungseinrichtung (9) sind monolithisch in einen Halbleiterchip (2) integriert. Die Messspule (3) kann auch durch Leiterbahnen einer Leiterplatte gebildet sein, auf der ein den Sensor und die Signalverarbeitungseinrichtung (9) aufweisender Halbleiterchip (2) angeordnet ist.

## Beschreibung

Die Erfindung betrifft eine Messvorrichtung zur Messung eines magnetischen Felds, mit mindestens einer Messspule und mit wenigstens einem Sensor zur Messung niederfrequenter Magnetfelder, welche Messspule und welcher Sensor mit ihrer Erstreckungsebene jeweils quer zur Flussrichtung des magnetischen Felds in diesem positioniert oder positionierbar sind, wobei die Messspule und der Sensor mit einer Signalverarbeitungseinrichtung verbunden sind, mit der in Abhängigkeit von einem von der Messspule bereitgestellten ersten Messsignal und einem vom Hallsensor bereitgestellten zweiten Messsignal ein dem magnetischen Feld im Wesentlichen entsprechendes Ausgangssignal generierbar ist. Dabei wird unter einem Sensor zur Messung niederfrequenter Magnetfelder ein Sensor verstanden, der bei niedrigen Frequenzen und/oder bei einem konstanten Magnetfeld eine größere Messgenauigkeit und/oder Messempfindlichkeit aufweist als die Messspule. Der Sensor zur Messung der niederfrequenten Magnetfelder kann insbesondere ein Hallsensor und/oder ein magnetoresistiver Sensor sein.

Eine derartige Messvorrichtung, die zur Messung eines von einem in einem Leiter fließenden elektrischen Strom erzeugten Magnetfeld vorgesehen ist, ist aus DE 698 02 203 T2 bekannt. Die Messvorrichtung hat eine Leiterplatte mit einer Öffnung, die von dem elektrischen Leiter normal zur Ebene der Leiterplatte durchsetzt wird. Auf die Leiterplatte ist als gedruckte Schaltung eine Rogowski-Spule aufgebracht, die den stromführenden Leiter umgrenzt. Zwischen der Rogowski-Spule und dem Leiter sind auf der Leiterplatte mehrere Hallsensoren montiert, die in regelmäßigen Abständen um den Leiter herum angeordnet sind. Mit Hilfe der Rogowski-Spule können insbesondere in dem Magnetfeld enthaltene hochfrequente Signalanteile mit großer Präzision gemessen werden. Mit den Hallsensoren lassen sich niederfrequente Signalanteile und der Gleichanteil des Magnetfelds messen. Seitlich neben der Rogowski-Spule sind elektrische Bauelemente für eine Signalverarbeitungseinrichtung montiert, die über Leiterbahnen mit der Rogowski-Spule und den Hallsensoren verbunden ist. Mit Hilfe der Signalverarbeitungseinrichtung wird aus den Messsignalen der Rogowski-Spule und der Hallsensoren ein Ausgangssignal gebildet, das ein Abbild des in dem Leiter fließenden Stromes ist.

Die Messvorrichtung ermöglicht zwar eine breitbandige Messung des elektrischen Stromes bzw. des von diesem induzierten Magnetfelds, ist jedoch noch relativ aufwändig und teuer. Auch weist die Messvorrichtung noch ziemlich große Abmessungen auf

Es besteht deshalb die Aufgabe, eine Messvorrichtung der eingangs genannten zu schaffen, die einen kostengünstigen und kompakten Aufbau ermöglicht.

Diese Aufgabe wird dadurch gelöst, dass die Messspule, der Sensor und die Signalverarbeitungseinrichtung monolithisch in einen Halbleiterchip integriert sind. Die Messspule kann dann mit Methoden der Halbleiterfertigung mit genau vorgegebenen, reproduzierbaren Abmessungen hergestellt werden. Auch kann die Messspule bei der Herstellung der Messvorrichtung sehr genau relativ zu dem Sensor positioniert werden. Die Messvorrichtung ermöglicht dadurch eine hohe Messgenauigkeit.

Vorteilhaft ist, wenn die Windungen der Messspule im Wesentlichen der Außenkontur des Halbleiterchips und/oder einer dazu etwa parallel beabstandeten Linie folgen. Dadurch kann nahezu der gesamte, die Chipfläche des Halbleiterchips durchsetzende magnetische Fluss für die Induktion einer elektrischen Spannung in der Messspule genutzt werden. Die Messvorrichtung ermöglicht dadurch eine hohe Messempfindlichkeit.

Die vorstehend genannte Aufgabe kann bei einer Messeinrichtung der eingangs genannten Art, bei welcher der Halbleiterchip auf einem flächigen Träger angeordnet ist und die Messspule durch mindestens eine Leiterbahn gebildet ist, die auf und/oder in dem Träger angeordnet ist, auch dadurch gelöst werden, dass der Sensor und die Signalverarbeitungseinrichtung monolithisch in einen auf dem Träger angeordneten Halbleiterchip integriert sind. Dabei kann der Träger eine starre, elektrisch isolierende Platte oder eine flexible, elektrisch isolierende Folie sein.

Bei einer bevorzugten Ausführungsform der Erfindung sind die von mindestens einer Windung der Messspule aufgespannte Ebene und die Erstreckungsebene des Sensors (der Sensoren) im Wesentlichen in der Haupterstreckungsebene des Halbleiterchips und/oder parallel dazu angeordnet sind. Der Sensor und/oder die Messspule können dann eine entsprechend große Fläche aufweisen, was eine hohe Sensitivität der Messvorrichtung ermöglicht.

Bei einer anderen vorteilhaften Ausgestaltung der Erfindung sind die von der mindestens einer Windung der Messspule aufgespannte Ebene und die Erstreckungsebene des Sensors (der Sensoren) quer und insbesondere etwa orthogonal Haupterstreckungsebene des Halbleiterchips angeordnet. Der Sensor und ggf die Messspule benötigen dann nur eine relativ kleine Chipfläche, so dass der Halbleiterchip kompakte Abmessungen aufweisen kann und entsprechend kostengünstig hergestellt werden kann.

Vorteilhaft ist, wenn die Messspule mindestens zwei voneinander beabstandete Leiterbahnebenen aufweist wenn die Leiterbahnen einer ersten Leiterbahnebene quer und vorzugsweise rechtwinklig zu den Leiterbahnen mindestens einer zweiten Leiterbahnebene verlaufen, und wenn die Leiterbahnen der ersten Leiterbahnebene über Durchkontaktierungen mit den Leiterbahnen der mindestens einen zweiten Leiterbahnebene verbunden sind. Die Messspule kann dann eine Vielzahl von Windungen aufweisen. Gegebenenfalls ist es sogar möglich, dass der Halbleiterchip zusätzlich zu den die Leiterbahnen für die Messspule aufweisenden Leiterbahnebene mindestens eine weitere Leiterbahnebene aufweist, in der für die Signalverarbeitungseinrichtung und/oder mindestens einen weiteren in den Halbleiterchip integrierten Schaltkreis benötigten Leiterbahnen angeordnet sind.

Bei einer anderen zweckmäßigen Ausgestaltung der Erfindung weist die Messspule in mindestens einer Leiterbahnebene eine Leiterbahn auf, die mehrere ineinander angeordnete Windungen hat. Dabei kann die Leiterbahn beispielsweise einen spiralförmigen oder polygonförmigen Verlauf haben.

Bei einer vorteilhaften Ausführungsform der Erfindung sind die Messrichtung der mindestens einen Messspule und die Messrichtung des wenigstens einen Sensors quer und insbesondere orthogonal zueinander angeordnet. Eine solche Anordnung wird bevorzugt für Anwendungen verwendet, bei denen das zu messende magnetische Feld mehrere normal zueinander angeordnete Komponenten Bₓ, B_{y}, B_{z} aufweist und bei denen diese Komponenten miteinander verknüpft sind. Eine solche Messeinrichtung kann insbesondere in einem Kraftfahrzeug Verwendung finden.

Zweckmäßigerweis ist der Sensor oder dessen orthogonale Projektion auf die Erstreckungsebene der Messspule innerhalb der Messspule angeordnet. Die auf dem Halbleiterchip zur Verfügung stehende Chipfläche kann dann besonders gut ausgenutzt werden.

Die erfindungsgemäße Messvorrichtung kann in einem Lage-, Geschwindigkeits-und/oder Beschleunigungssensor enthalten sein, die zumindest einen Magnetpole aufweisenden Geber hat, der derart relativ zu der Messvorrichtung gelagert ist, dass die Magnetpole an der Messvorrichtung vorbei bewegbar sind. Mit Hilfe der Messvorrichtung kann dann die Bewegung des Gebers über einen weiten Geschwindigkeitsbereich mit großer Präzision erfasst werden. Die Magnetpole können mindestens einen Permanentmagnet und/oder eine Polspule aufweisen.

Bei einer vorteilhaften Ausgestaltung der Erfindung ist der Geber relativ zu der Messvorrichtung verdrehbar gelagert. Ein solcher Geber kann beispielsweise zur Erfassung der Lage, Winkelgeschwindigkeit und/oder Winkelbeschleunigung eines rotierenden Maschinenteils, wie z.B. einer Welle, eines rotierenden Teils einer Verbrennungsmaschine oder eines Rotors einer elektrischen Maschine vorgesehen sein.

Bei einer anderen vorteilhaften Ausführungsform der Erfindung ist der Geber relativ zu der Messvorrichtung verschiebbar gelagert. Eine derartige Messvorrichtung kann insbesondere an einem Linearmotor einer Schiebeführung und/oder einem Ventilschaft angeordnet sein.

Nachfolgend sind Ausführungsbeispiele der Erfindung anhand der Zeichnung näher erläutert. Es zeigen:
- Fig. 1: eine Aufsicht auf ein erstes Ausführungsbeispiel eines Halbleiterchips, in den eine Messspule, ein Hallsensor und eine Signalverarbeitungseinrich-tung monolithisch integriert sind, wobei die Hallplatte des Hallsensors und die Signalverarbeitungseinrichtung nur schematisch dargestellt sind,

- Fig. 2: eine Aufsicht auf ein zweites Ausführungsbeispiel eines Halbleiterchips, in den eine so genannte vertikale Hallplatte integriert ist,
- Fig. 3: eine Messvorrichtung, bei der die Messspule und ein den Hallsensor und die Signalverarbeitungseinrichtung enthaltender Halbleiterchip auf einer Leiterplatte angeordnet sind,
- Fig.4: ein weiteres Ausführungsbeispiel der Messvorrichtung, bei der die von den Windungen der Messspule aufgespannten Ebenen etwa orthogonal zur Erstreckungsebene der Leiterplatte verlaufen,
- Fig. 5: einen Querschnitt durch ein erstes Ausführungsbeispiel eines Lage-, Geschwindigkeits- und/oder Beschleunigungssensors,
- Fig.6: einen Querschnitt durch ein zweites Ausführungsbeispiel eines Lage-, Geschwindigkeits- und/oder Beschleunigungssensors, und
- Fig. 7: eine Messvorrichtung zur Erfassung eines Messsignals, das dem elektrischen Strom in einem Leiter entspricht.

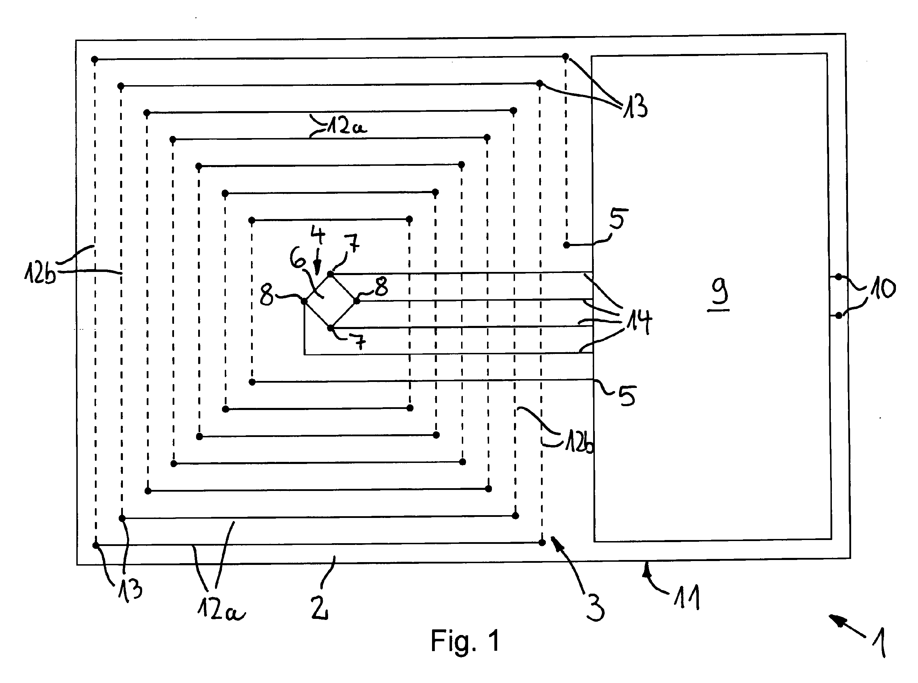

Eine in Fig. 1 im Ganzen mit 1 bezeichnete Messvorrichtung zur Messung eines magnetischen Felds hat einen Halbleiterchip 2, in den eine Messspule 3 und ein Hallsensor 4 monolithisch integriert sind. Die Messspule 3 und der Hallsensor 4 sind mit ihren Erstreckungsebenen jeweils etwa in der von dem Halbleiterchip 2 aufgespannten Eben angeordnet, die der Zeichenebene in Fig. 1 entspricht. Der magnetische Fluss des zu messenden magnetischen Felds verläuft quer und vorzugsweise rechtwinklig zu dieser Ebene.

Die Messspule 3 hat an ihren Enden erste elektrische Anschlüsse 5, an denen ein erstes Messsignal anliegt, das der bei einer Änderung des magnetischen Felds in der Messspule 3 induzierten elektrischen Spannung entspricht. Das erste erstes Messsignal ist gemäß den Induktionsgesetz etwa proportional zur Änderungsgeschwindigkeit des magnetischen Felds, weshalb in dem magnetischen Feld enthaltene höherfrequente Signalanteile in dem Messsignal stärker repräsentiert sind, als niederfrequente Signalanteile. Ein eventueller in dem magnetischen Feld enthaltener Gleichanteil verursacht kein Messsignal an der Messspule 3.

Der Hallsensor 4 weist eine Hallplatte 6 auf, an der zwei voneinander beabstandete zweite elektrische Anschlüsse 7 vorgesehen sind, in die ein Konstantstrom eingespeist wird, der von einer in der Zeichnung nicht näher dargestellten Messstromquelle bereitgestellt wird. An der Hallplatte 6 sind ferner dritte elektrische Anschlüsse 8 zum Abgreifen einer durch das magnetische Feld bewirkten Hallspannung vorgesehen. Die Hallspannung wird nachstehend auch als zweites Messsignal bezeichnet, In dem zweiten Messsignal sind sowohl ein in dem magnetischen Feld enthaltener Gleichanteil als auch ein Wechselanteil berücksichtigt. Mit zunehmender Frequenz des magnetischen Felds nimmt jedoch das zweite Messsignal ab.

Die ersten elektrischen Anschlüsse 6 und die dritten elektrischen Anschlüsse 8 sind jeweils mit einem Eingang einer Signalverarbeitungseinrichtung 9 verbunden, die als elektrische Schaltung monolithisch in den Halbleiterchip 2 integriert ist. Die Signalverarbeitungseinrichtung 9 erzeugt in Abhängigkeit von dem ersten Messsignal und dem zweiten Messsignal ein dem magnetischen Feld entsprechendes Ausgangssignal, das an einem Ausgang 10 abgreifbar ist. In dem Ausgangssignal sind der Gleichanteil des magnetischen Felds sowie niederfrequente und hochfrequente Anteile gleichermaßen berücksichtigt, so dass sich eine über einen weiten Frequenzbereich nahezu linearer Frequenzgang ergibt.

In Fig. 1 ist erkennbar, das die Messspule 3 mehre Windungen aufweist, die jeweils aus mehreren geraden Leiterbahnstücken zusammengesetzt sind. Die einzelnen Leiterbahnstücke verlaufen jeweils entlang einer parallel zur Außenkontur 11 des Halbleiterchips 2 verlaufenden Linie. Ausgehend von der Mitte der Messspule 3 zum Rand des Halbleiterchips 2 hin nimmt die Länge der geraden Leiterbahnstücke von Windung zu Windung zu.

Die Messspule 3 hat zwei parallel zueinander beabstandete Leiterbahnebenen. Die Leiterbahnen 12a einer ersten Leiterbahnebene sind in der Zeichnung als durchgezogene Linie und die Leiterbahnen 12b einer zweiten Leiterbahnebene als strichlinierte Linien dargestellt. Deutlich ist erkennbar, dass die Leiterbahnen 12a der ersten Leiterbahnebene in der Aufsicht auf den Halbleiterchip 2 etwa rechtwinklig zu den Leiterbahnen 12b der zweiten Leiterbahnebene verlaufen. Die Leiterbahnen 12a, 12b der unterschiedlichen Leiterbahnebene sind durch Durchkontaktierungen miteinander verbunden.

Der Hallsensor 4 oder dessen orthogonale Projektion auf die Erstreckungsebene der Messspule 3 ist innerhalb der Messspule 3 in dem von der innersten Windung umgrenzten Raum angeordnet. Die Verbindungsleiterbahnen 14 zwischen der Hallplatte 6 und der Signalverarbeitungseinrichtung verlaufen in der ersten Leiterbahnebene zwischen den Leiterbahnen 12a.

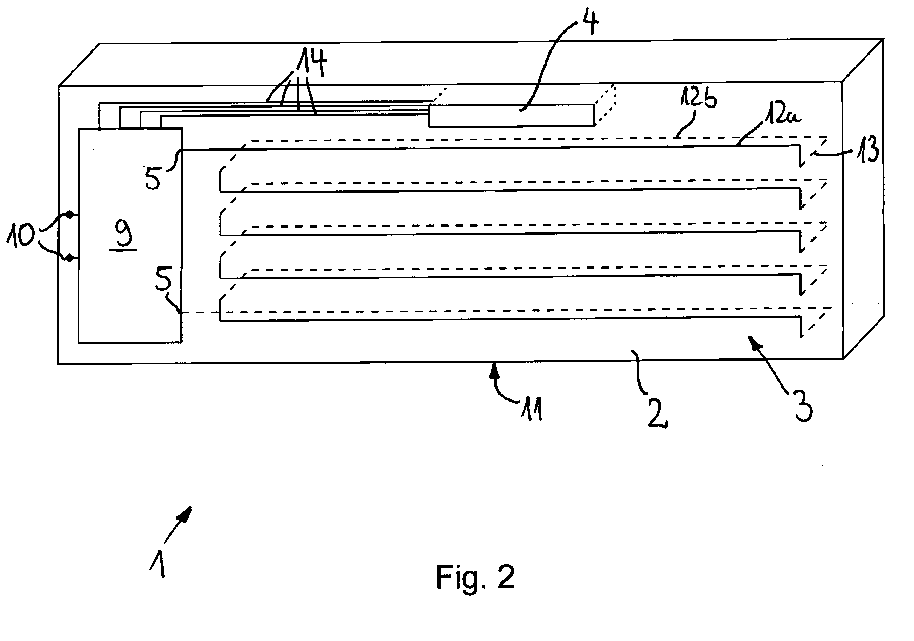

Bei dem in Fig. 2 gezeigten Ausführungsbeispiel ist die Ebene, in der sich die Hallplatte 6 erstreckt, orthogonal zur Haupterstreckungsebene des Halbleiterchips 2 angeordnet. Die Windungen der Messspule 3 verlaufen etwa parallel zur Ebene der Hallplatte 6.

Die Messspule 3 hat zwei parallel zueinander beabstandete Leiterbahnebenen. Die Leiterbahnen 12a einer ersten Leiterbahnebene sind in der Zeichnung als durchgezogene Linie und die Leiterbahnen 12b einer zweiten Leiterbahnebene sowie die Durchkontaktierungen 13 sind jeweils als strichlinierte Linien dargestellt. Die Leiterbahnen 12a der ersten Leiterbahnebene verlaufen etwa parallel zu den Leiterbahnen 12b der zweiten Leiterbahnebene.

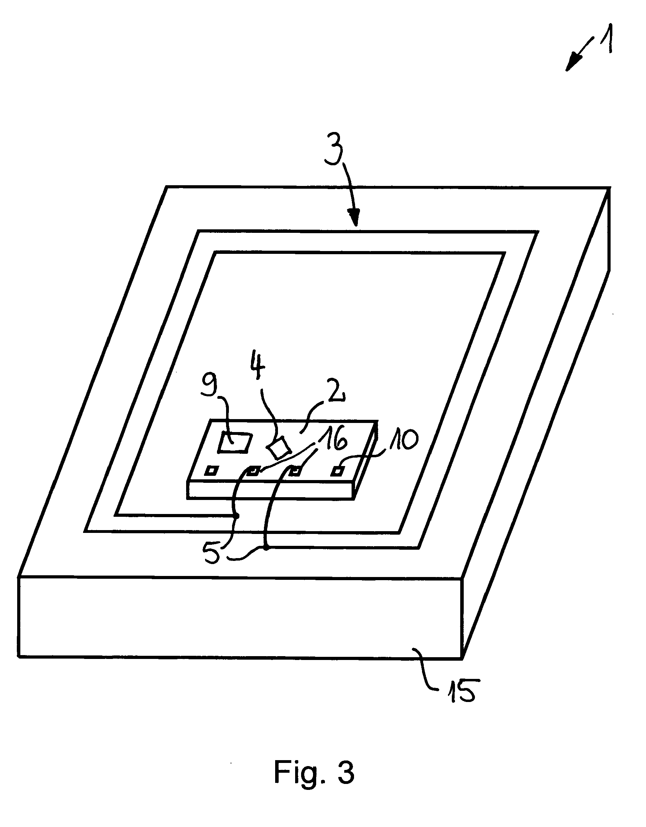

Bei dem in Fig. 3 gezeigten Ausführungsbeispiel ist der Halbleiterchip 2 auf einer Leiterplatte angeordnet, die einen flächigen Träger 15 aufweist, auf und/oder in dem eine elektrische Leiterbahn angeordnet ist, welche die Messspule 3 bildet. Der Hallsensor 4 und die Signalverarbeitungseinrichtung 9 sind monolithisch in den Halbleiterchip 2 integriert. Die Signalverarbeitungseinrichtung 9 ist über auf dem Halbleiterchip 2 vorgesehene Anschlusskontakte 16 mit den Enden der Messspule 3 elektrisch verbunden, beispielsweise über Lötstellen. Die Erstreckungsebenen des Halbleiterchips 2 und der Hallplatte des Hallsensors 4 verlaufen etwa parallel zur Ebene des Trägers 15. Die Windungen der Messspule 3 verlaufen im Wesentlichen um den Halbleiterchip 2 herum. Bei Bedarf kann die Leiterplatte 15 mehrere Lagen mit Leiterbahnen aufweisen, die jeweils einen Abschnitt der Messspule 3 bilden. Dadurch wird eine größere Anzahl Windungen ermöglicht. Die einzelnen Leiterbahnlagen können über Durchkontaktierungen in Reihe geschaltet und/oder mit den Anschlusskontakten 16 verbunden sein.

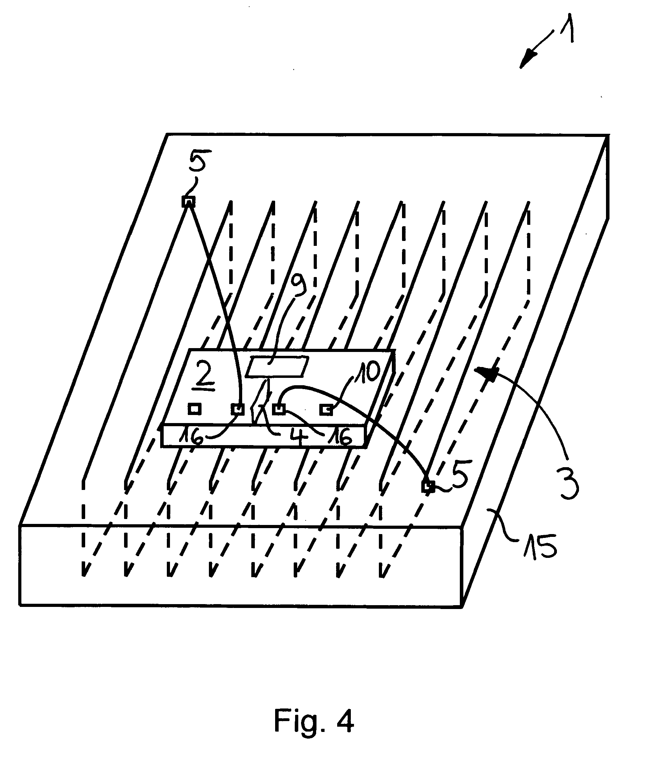

Bei dem in Fig. 4 gezeigten Ausführungsbeispiel sind die Leiterbahnen für die Messspule 3 derart auf dem Träger 15 angeordnet, dass die von den Windungen der Messspule 3 aufgespannten Ebenen etwa orthogonal zur Erstreckungsebene des Trägers 15 verlaufen. Die Leiterplatte hat zwei Ebenen mit Leiterbahnen, die quer zur Erstreckungsebene des Trägers 15 voneinander beabstandet sind. Jede Leiterbahnebene hat mehrere, etwa parallel zueinander verlaufende Leiterbahnstücke, die über Durchkontaktierungen mit ihnen zugeordneten Leiterbahnstücken einer weiteren Leiterbahnebene verbunden sind.

Der Halbleiterchip 2 ist über der Messspule 3 auf dem Träger 15 angeordnet. Die Ebene, in der sich der Halbleiterchip 2 erstreckt, verläuft etwa parallel zur Erstreckungsebene des Trägers 15. Wie bei dem Ausführungsbeispiel gemäß Fig. 3 sind der Hallsensor 4 und die Signalverarbeitungseinrichtung 9 monolithisch in den Halbleiterchip 2 integriert. Die Signalverarbeitungseinrichtung 9 ist über auf dem Halbleiterchip 2 vorgesehene Anschlusskontakte 16 an den Enden der Messspule 3 angeschlossen. Die Ebene, in der sich die Hallplatte 6 erstreckt, ist orthogonal zur Erstreckungsebene des Halbleiterchips 2 angeordnet.

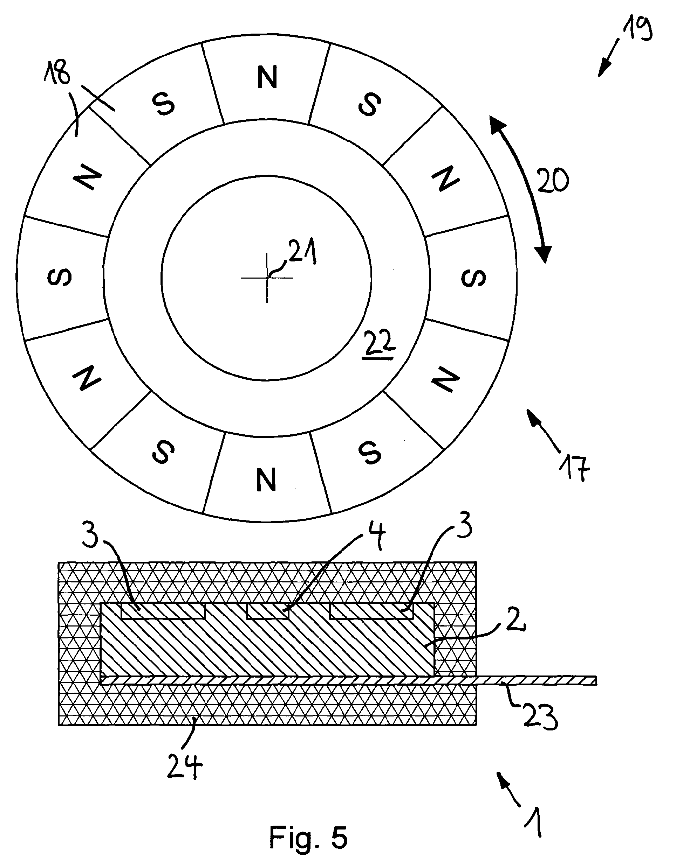

Die Messvorrichtung 1 kann in einem Lage-, Geschwindigkeits- und/oder Beschleunigungssensor 19 angeordnet sein. Diese hat einen relativ zu der Messvorrichtung 1 in Richtung des Doppelpfeils 20 bewegbar gelagerten Geber 17, der bei dem in Fig. 5 gezeigten Ausführungsbeispiel als drehbar auf einer Achse 21 gelagertes Geberrad ausgestaltet ist. Der Geber 17 hat mehrere etwa in radialer Richtung magnetisierte permanentmagnetische Magnetpole 18, die am Außenumfang des Gebers 17 in Umfangsrichtung hintereinander angeordnet sind. Dabei wechseln sich jeweils Nord- und Südpole einander ab. Die Magnetpole 18 sind am Innenumfang des Gebers durch eine magnetisch leitendes Joch 22 miteinander verbunden.

Die Magnetpole 18 sind an der Messvorrichtung 1 vorbei bewegbar und verursachen dabei einen magnetischen Wechselfluss, der die Messspule 3 und die Hallplatte 6 jeweils etwa orthogonal zu deren Erstreckungsebene durchsetzen. In dem Ausgangssignal der Signalverarbeitungseinrichtung 9 wird bei jedem Vorbeibewegen eines Magnetpols 18 an der Messvorrichtung 1 ein Impuls oder eine Impulslücke erzeugt, und zwar auch dann, wenn sich die Magnetpole 18 mit sehr geringer oder mit hoher Geschwindigkeit an der Messvorrichtung 1 vorbeibewegen.

In Fig. 5 ist noch erkennbar, dass der Halbleiterchip 2 auf einem Frame 23 angeordnet und mit einer verfestigten Vergussmasse 24, beispielsweise einem elektrisch isolierenden Kunststoff, umspritzt ist.

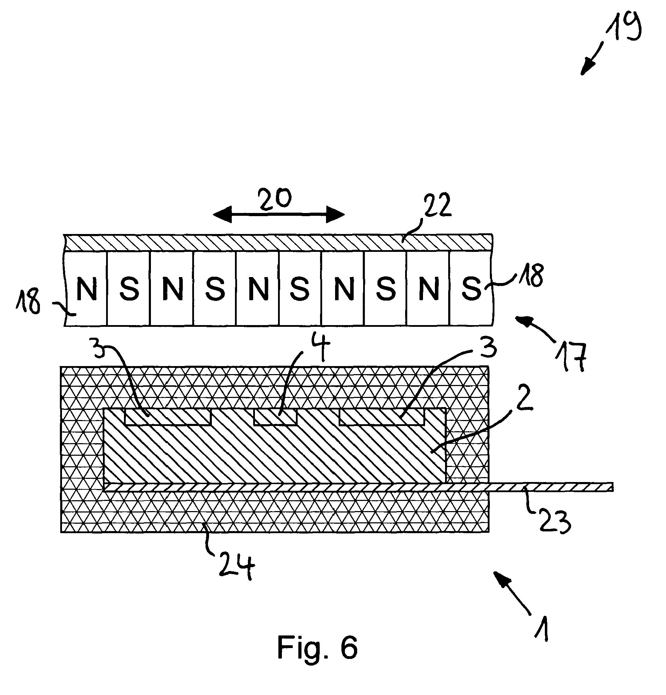

Bei dem Lage-, Geschwindigkeits- und/oder Beschleunigungssensor 19 gemäß Fig.6 ist der Geber 17 relativ zu der Messvorrichtung 1 parallel zur Ebene des Halbleiterchips 2 verschiebbar. Die Magnetpole 18 sind in einer in Verschieberichtung verlaufenden Reihe auf einem weichmagnetischen Joch 22 nebeneinander angeordnet.

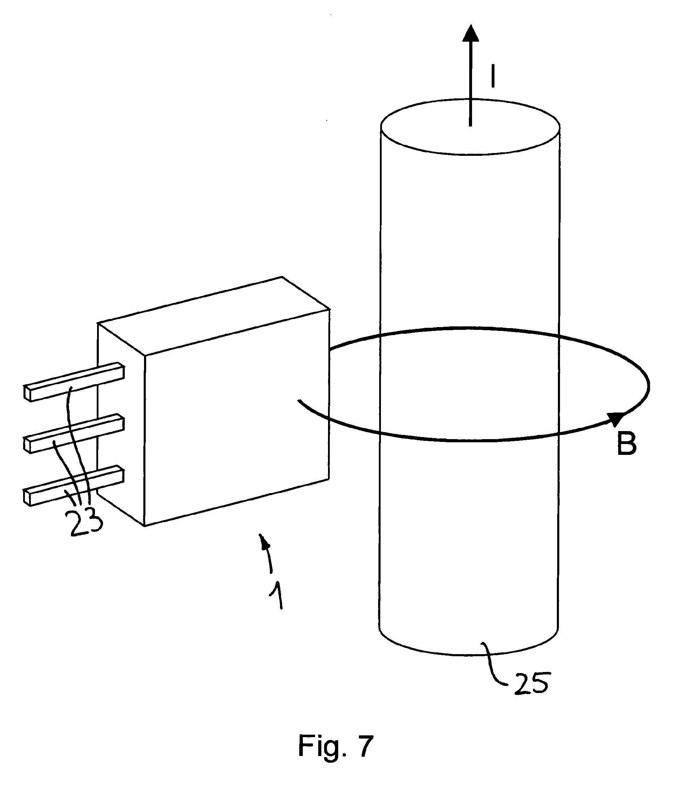

Bei dem in Fig. 7 gezeigten Ausführungsbeispiel ist die Messvorrichtung 1 derart benachbart zu einem einen elektrischen Strom 1 führende elektrischen Leiter 25 angeordnet, dass der von dem elektrischen Strom 1 induzierte magnetische Fluss B die Messspule 3 und die Hallplatte 5 jeweils etwa orthogonal zu deren Erstreckungsebene durchsetzen. Die Signalverarbeitungseinrichtung 9 ist derart ausgestaltet, dass ihr Ausgangssignal ein Abbild des durch den Leiter 25 fließenden elektrischen Stromes ist. Die Messvorrichtung 1 kann über eine in der Zeichnung nicht näher dargestellten Halterung in einer vorbestimmten Lage relativ zu dem Leiter 25 positioniert sein.

## Patentansprüche

1. Messvorrichtung (1) zur Messung eines magnetischen Felds (B), mit mindestens einer Messspule (3) und mit wenigstens einem Sensor zur Messung niederfrequenter Magnetfelder, welche Messspule (3) und welcher Sensor mit ihrer Erstreckungsebene jeweils quer zur Flussrichtung des magnetischen Felds (B) in diesem positioniert oder positionierbar sind, wobei die Messspule (3) und der Sensor mit einer Signalverarbeitungseinrichtung (9) verbunden sind, mit der in Abhängigkeit von einem von der Messspule (3) bereitgestellten ersten Messsignal und einem vom Sensor bereitgestellten zweiten Messsignal ein dem magnetischen Feld (B) im Wesentlichen entsprechendes Ausgangssignal generierbar ist, **dadurch gekennzeichnet, dass** die Messspule (3), der Sensor und die Signalverarbeitungseinrichtung (9) monolithisch in einen Halbleiterchip (2) integriert sind.

2. Messvorrichtung (1) nach Anspruch 1, **dadurch gekennzeichnet, dass** die Windungen der Messspule (3) im Wesentlichen der Außenkontur (11) des Halbleiterchips (2) und/oder einer dazu etwa parallel beabstandeten Linie folgen.

3. Messvorrichtung (1) nach dem Oberbegriff von Anspruch 1, wobei der Halbleiterchip (2) auf einem flächigen Träger angeordnet ist, wobei die Messspule (3) durch mindestens eine Leiterbahn gebildet ist, die auf und/oder in dem Träger angeordnet ist, **dadurch gekennzeichnet, dass** der Sensor und die Signalverarbeitungseinrichtung (9) monolithisch in einen auf dem Träger angeordneten Halbleiterchip (2) integriert sind.

4. Messvorrichtung (1) nach einem der Ansprüche 1 bis 3, **dadurch gekennzeichnet, dass** die von mindestens einer Windung der Messspule (3) aufgespannte Ebene und die Erstreckungsebene des Sensor (der Sensoren) im Wesentlichen in der Haupterstreckungsebene des Halbleiterchips (2) und/oder parallel dazu angeordnet sind.

5. Messvorrichtung (1) nach einem der Ansprüche 1 bis 4, **dadurch gekennzeichnet, dass** die von der mindestens einen Windung der Messspule (3) aufgespannte Ebene und die Erstreckungsebene des Sensors (der Sensoren) quer und insbesondere etwa orthogonal Haupterstreckungsebene des Halbleiterchips (2) angeordnet sind.

6. Messvorrichtung (1) nach einem der Ansprüche 1 bis 5, **dadurch gekennzeichnet, dass** die Messspule (3) mindestens zwei voneinander beabstandete Leiterbahnebenen (12a, 12b) aufweist, dass die Leiterbahnen (12a) einer ersten Leiterbahnebene quer und vorzugsweise rechtwinklig zu den Leiterbahnen (12b) mindestens einer zweiten Leiterbahnebene verlaufen, und dass die Leiterbahnen (12a) der ersten Leiterbahnebene über Durchkontaktierungen (13) mit den Leiterbahnen (12b) der mindestens einen zweiten Leiterbahnebene verbunden sind.

7. Messvorrichtung (1) nach einem der Ansprüche 1 bis 6, **dadurch gekennzeichnet, dass** die Messspule (3) in mindestens einer Leiterbahnebene eine Leiterbahn (12a, 12b) aufweist, die mehrere ineinander angeordnete Windungen hat.

8. Messvorrichtung (1) nach einem der Ansprüche 1 bis 7, **dadurch gekennzeichnet, dass** die Messrichtung der mindestens einen Messspule (3) und die Messrichtung des wenigstens einen Sensors quer und insbesondere orthogonal zueinander angeordnet sind.

9. Messvorrichtung (1) nach einem der Ansprüche 1 bis 8, **dadurch gekennzeichnet, dass** der Sensor oder dessen orthogonale Projektion auf die Erstreckungsebene der Messspule (3) innerhalb der Messspule (3) angeordnet ist.

10. Lage-, Geschwindigkeits- und/oder Beschleunigungssensor (19), mit mindestens einer Messvorrichtung (1) nach einem der Ansprüche 1 bis 9 und mit zumindest einem Magnetpole (18) aufweisenden Geber (17), der derart relativ zu der Messvorrichtung (1) gelagert ist, dass die Magnetpole (18) an der Messvorrichtung (1) vorbei bewegbar sind.

11. Lage- Geschwindigkeits- und/oder Beschleunigungssensor (19) nach Anspruch 10, **dadurch gekennzeichnet, dass** der Geber (17) relativ zu der Messvorrichtung (1) verdrehbar gelagert ist.

12. Lage- Geschwindigkeits- und/oder Beschleunigungssensor (19) nach Anspruch 11, **dadurch gekennzeichnet, dass** der Geber (17) relativ zu der Messvorrichtung (1) verschiebbar gelagert ist.
